# EUROPEAN PATENT APPLICATION

(11) **EP 3 979 248 A1**
(43) Date of publication of application: **06.04.2022**
(21) Application number: 20199346.6
(22) Date of filing: 30.09.2020
(51) Int. Cl.: G11C 8/04, G11C 7/10, G11C 8/12, G11C 8/16, G11C 29/10, G11C 29/16, G11C 29/18, G11C 29/34, G11C 29/36

(54) **A MEMORY MACRO**

(71) Applicant: Imec VZW, 3001 Leuven (BE); Stichting IMEC Nederland, 5656 AE Eindhoven (NL)
(72) Inventor: Catthoor, Francky, 3001 Leuven (BE); Stuijt, Jan, 3001 Leuven (BE); Pande, Sandeep, 3001 Leuven (BE)
(74) Representative: IP HILLS NV

(57) **Abstract**

The present disclosure relates to a memory macro comprising a memory array and a periphery circuitry configured to read data from and/or write data to the memory array, wherein the periphery circuitry comprises a programmable circuitry causing the memory macro to access data stored in the memory array in accordance with manifest loop instructions; the programmable circuitry comprising a control logic configured to control the operation of the periphery circuitry in accordance with a set of parameters derived from the manifest loop instructions. The present disclosure further relates to a method for controlling the operation of a memory macro and to a processing system comprising the memory macro.

## Description

### Technical Field

Various example embodiments relate to a memory macro and a processing system comprising the memory macro.

### Background

One of the most critical challenges for today's and future data-intensive and big-data problems is data storage and analysis. The increase of the data size surpasses the capabilities of today's computation architectures which suffer from limited bandwidth due to communication and memory-access bottlenecks as well as limited scalability due to CMOS technology and energy inefficiency.

In-memory processing is an emerging technology aiming at processing of the data stored in memory. In-memory processing is based on the integration of the storage and computation, where the computing result is produced within the memory array which is designed to perform a specific operation such as bit-wise logical operation, Boolean vector-matrix multiplications or analog vector-matric multiplications. Typically, the memory array is non-volatile, NVM, such as a resistive RAM, e.g. oxide-based RAM, OxRAM, a phase change memory, PCM, a Spin-Transfer Torque Magnetic RAM, STT-MRAM, or a Spin-Orbit Torque MRAM, SOT-MRAM. By processing the data stored in the memory, data transfers to and from the main memory which are time consuming and energy expensive is limited to minimum. Eliminating this overhead allows the data to be processed in real-time. However, in-memory processing requires a costly memory array redesign, leading to a high non-recurring engineering, NRE, thus making it less practical for many use cases.

### Summary

Amongst others, it is an object of embodiments of the present disclosure to provide a low-cost alternative to in-memory processing technology offering comparable high throughput, low latency, and energy consumption without incurring the excessive NRE cost.

The scope of protection sought for various embodiments of the invention is set out by the independent claims. The embodiments and features described in this specification that do not fall within the scope of the independent claims, if any, are to be interpreted as examples useful for understanding various embodiments of the invention.

This object is achieved, according to a first example aspect of the present disclosure, by a memory macro, comprising a memory array and a periphery circuitry configured to access the memory array, wherein the periphery circuitry comprises a programmable circuitry causing the memory macro to access data stored in the memory array in accordance with manifest loop instructions; the programmable circuitry comprising a control logic configured to control the operation of the periphery circuitry in accordance with a set of parameters derived from the manifest loop instructions.

In other words, a memory macro comprises a memory array and a periphery circuitry that controls how data is written into and read from the memory array. The memory array may be volatile such as static or dynamic RAM or non-volatile such as flash, resistive or magnetic RAM. The memory array may be a two-dimensional, a three-dimensional or a higher-dimensional array. The periphery circuitry is provided with a programmable circuitry that enables the memory macro to access data stored in the memory in accordance with manifest loop instructions. To do so, the programmable circuitry comprises a control logic that is configured to derive a set of parameters in accordance with the manifest loop instructions and to control the operation of the periphery circuitry and therefore to control in real time the writing and reading of data in the memory array in accordance with the set of parameters derived from the manifest loop instructions.

Manifest loop instructions are instructions that implement a loop structure characterized by a static control flow, i.e. the control flow of the loop is data-independent and hence it can be analysed by a compiler at compile-time without having to execute the loop structure. The loop structure, such as a "for" or a "while" loop, is an iterative function comprising a set of instructions that defines how data stored in the memory is to be processed. In other words, the manifest loop instructions include the memory addressing to the stored data. The manifest loop instructions may further comprise a stride operation that defines how the loop iterator is progressing within the loop structure. A stride operation implementing increments of one or more are supported. In addition, the manifest loop instructions may require the selection of multiple columns and/or rows in the memory that are not necessarily consecutive or neighbouring. Furthermore, the manifest loop instructions may comprise instructions for one or more loop structures. Depending on the instructions of the respective loop structures, the data in the different segments of the memory array may be accessed in the same or different manner. Furthermore, the one or more loop structures may be nested loop structures with multiple loop iterators.

By processing the manifest loop instructions and deriving therefrom a set of parameters, the memory addressing, indicating how to address the memory array, is parameterized. This parametrization allows parallel addressing of the data stored in one or more parts or segments of the memory array which may not necessarily be consecutive or neighbouring. It further allows simultaneous addressing of the data in nested loop structures. Also, it allows supporting strides with different increments.

This way by simply modifying the periphery circuitry while maintaining the memory array unchanged, the memory macro is able to access the stored data in a programmable way , thereby enabling flexible and complex memory addressing schemes without having to supply addresses from an external address calculation unit. It makes conventional solutions for this like load-store (LS) units, direct-memory-access (DMA), or memory management units (MMUs) obsolete. As a result, a cost-effective alternative to in-memory processing offering comparable overall performance in terms of throughput, latency is achieved.

Moreover, by employing a non-volatile memory array, such as Flash, resistive RAM, or a magnetic RAM, that a denser than SRAM memory, low leakage and a significant area reduction may further be achieved.

According to an example embodiment, the programmable circuitry is configured, during operation, to receive the manifest loop instructions from an instruction set processor and to derive the set of parameters therefrom.

In other words, during operation, i.e. in real-time, the instruction set processor provides to the programmable circuitry manifest loop instructions in the form of lower-level instructions understandable by the control logic such as assign, select and shift operations. Typically, a single "for" loop structure is decomposed at design-time into a vast amount of such manifest loop instructions. The manifest loop instructions include memory addressing instructions. In this case, the memory addressing instructions control the operation of the periphery circuitry of the memory macro. The programmable circuitry then processes these instructions and derives therefrom the set of parameters which are then used to control the operation of the periphery circuitry of the memory macro.

According to an example embodiment, the set of parameters comprises a memory address pattern, U, a stride, S, and a number of loop iterations, L.

The loop iteration L parameter indicates the number of times the manifest loop instructions in that iterator level are to be executed, while the other parameters indicate which data is to be processed. The memory address pattern, U, indicates the bit cells to be selected or addressed. In other words, the memory address pattern indicates the sequence of bit cells to which data is written into or read from. Typically, the first index in the memory address pattern U indicates the start memory address, P, i.e. the start memory location - the row and column of the memory array - from which the bit cells are to be selected. According to another embodiment, the start memory address, P, may be provided as a separate parameter. Providing the start memory address, P, as a separate parameter P allows to maintain the memory address pattern U relatively short in case the row and columns of the memory array are very long. The stride, S, parameter indicates how to derive the next memory address for a subsequent value of the loop iterator.

In the case the manifest loop instructions comprise instructions for nested loop structure, one set of parameters, i.e. U, S, L, and optionally P, will be provided for each loop structures in the nest.

According to an example embodiment, the programmable circuitry comprises a set of programmable registers configured to store the set of parameters.

According to an example embodiment, the programmable circuitry comprises a logic circuitry configured to perform a logical shift operation and to store the start memory address, P, and wherein the control logic is configured to shift the stored start memory address, P, in the logic circuitry in accordance with the stride parameter, S.

In other words, the control logic is configured to shift the start memory address, P, in accordance with the value of the stride parameter, S. This is done by storing the value of the parameter P in a shift register and then shifting the stored value in accordance with the value of the stride parameter, S. A shift operation to the right or left may for example be performed. The use of simple and low-cost logic circuitry allows to control the memory addressing and therefore the data to be processed by the memory macro at a specific loop iteration in an easy and a low-cost manner.

According to an example embodiment, the logic circuitry comprises one or more rotating shift registers or one or more chains of shift registers.

According to an example embodiment, the one or more rotating shift registers or the one or more chains of shift registers are hierarchically stacked and wherein the control logic is configured to control the hierarchically stacked shift registers such that the data stored in the memory array is processed in accordance with the manifest loop instructions.

Hierarchically stacked shift registers enable the memory macro to support manifest loop nest instructions such as deeply nested loops or nested loops structures that with multiple iterators or with pointers that may not be flattened into a single pointer. In such a case, a rotating shift register or a chain of shift register is provided for a respective level of the loop nest. For example, in case of two or more nested "for" loops, the rotating shift register corresponding to the inner loop starts again at the initial position, i.e. the start memory address, when the end of the loop, indicated by the loop iteration parameter L, is reached. At that time also the outer loop iterator is shifted by the value of the stride parameter of that outer loop. This further allows the memory macro to support compiler unflatten manifest loop nest instructions.

According to an example embodiment, the periphery circuitry is arranged to select one or more groups of consecutive rows of the memory array in accordance with the set of parameters.

According to an example embodiment, the periphery circuitry is arranged to select one or more groups of consecutive columns of the memory array in accordance with the set of parameters.

A group of rows may be a row or a number of consecutive rows, for example, two, three or more. Similarly, a group of columns may be a row or a number of consecutive columns, for example, two, three, or more. By selecting one or more groups of consecutive rows and/or one or more groups of consecutive columns, only the bit cells containing data to be processed is accessed. Thus, no additional data is read or stored. This improves the overall performance and energy consumption of the memory macro as only the required data is read from or written into the memory.

According to an example embodiment, the periphery circuitry comprises an output logic arranged to select columns of the memory array, and wherein the programmable circuitry is configured to control the operation of the output logic in accordance with the derived set of parameters and therefore in accordance with the manifest loop instructions.

According to an example embodiment, the periphery circuitry further comprises an input logic arranged to select rows to the memory array and wherein the programmable circuitry is configured to control the operation of the input logic in accordance with the derived set of parameters and therefore in accordance with the manifest loop instructions.

The programmable circuitry controls the output logic and/or the input logic of the periphery circuitry in accordance with the derived set of parameters. The set of parameters may comprise values for the respective input and output logic. These values may be the same or different. In other words, the operation of the output logic and/or the input logic may be controlled separately and independently from one another. For example, the programmable circuitry may control the output logic alone or together with the input logic and vice versa. This provides much more control flexibility and therefore enables more complex data processing.

According to an example embodiment, the programmable circuitry is configured, during operation, to derive a set of parameters for the input logic and the output logic, respectively.

According to an example embodiment, the memory address pattern, U, comprises a column selection pattern, Uc, and a row selection pattern, Ur.

The programmable circuitry may derive one set of parameters for the control of the output logic and another set of parameters for the control of the input logic. The parameters include a number of loop iterations, L, a stride parameter, S, and the memory address pattern, U, represented by a column selection pattern, Uc, and a row selection pattern, Ur. The stride parameter may comprise a stride parameter for the rows, Sr, and the columns, Sc. In embodiments, where the start memory address, P, is provided as a separate parameter, the parameter P may be represented by an initial or start column address, Pc, an initial or start row address, Pr. This allows to maintain the parameters Ur and Uc shorter when the rows and columns are the memory array are very long.

All the parameters to both the input and output logic may have the same or different values. The parameters for the output logic thus include a column selection pattern, Uc, indicating the columns to be selected or addressed, an initial column, Pc, indicating the start column from which the columns indicated in the Uc parameter are to be selected, and a stride parameter, Sc, indicating how to derive the initial column for a subsequent loop iteration. The parameters for the input logic include a row selection pattern, Ur, indicating the rows to be selected or addressed, an initial row, Pr, indicating the start row from which the rows indicated in the Ur parameter are to be selected, and a stride parameter, Sr, indicating how to derive the initial row for a subsequent loop iteration. The stride parameter Sc and Sr may have the same or different values.

In the case of hierarchically stacked registers, all of the above parameters are derived for a respective level of the stacked registers.

According to a second example aspect a method for controlling the operation of a memory macro according to the first aspect is disclosed, the method comprising:
- obtaining manifest loop instructions;
- deriving a set of parameters based on the manifest loop instructions; and
- controlling the operation of the memory macro in accordance with the set of parameters.

According to a third example aspect, a processing system is disclosed comprising a memory macro according to the first example aspect.

The various example embodiments of the first example aspect may be applied as example embodiments to the second and third example aspects.

### Brief Description of the Drawings

Some example embodiments will now be described with reference to the accompanying drawings.
FIG.1A shows a schematic illustration of a memory macro according to an example embodiment of the present disclosure;
FIG.1B shows a schematic illustration of a memory array according to an example embodiment of the present disclosure;
FIG.2 shows steps for processing data stored in a memory macro according to an example embodiment of the present disclosure;
FIG.3 shows a block scheme of a memory macro according to an example embodiment of the present disclosure;
FIG.4 shows a selection of groups of columns according to an example embodiment of the present disclosure;
FIG.5 shows a parallel write and read of bits into groups of consecutive columns according to an example embodiment of the present disclosure; and
FIG.6 shows a serialized addressing of groups of bits in multiple rows according to an example embodiment of the present disclosure.
FIG.7 shows a block scheme of a hyperplane pattern generator according to an embodiment of the present disclosure;
FIG.8 shows an example of a generated memory pattern sequence; and
FIG.9 shows an exemplary embodiment of addressing a three-dimensional memory array according to the present disclosure.

### Detailed Description of Embodiment(s)

A standard memory accesses a single word per memory address, which is a serious bottleneck for high-speed applications, such as image processing or video streaming. This bottleneck may be partially alleviated by making the word size very large, such that multiple words can be written or read in a single clock cycle as one large word. However, if only a few bits of such a large word need to be accessed, the memory will still access all bits within the large word, thereby wasting a lot of energy on the unused bits.

The present disclosure describes a solution according to which the periphery circuitry of the memory macro is enhanced with a programmable circuitry while keeping the memory array unchanged. The programmable circuitry allows parallel addressing of the data stored in one or more parts or segments of the memory array in a single memory cycle. The addressed parts or segments may not necessarily be consecutive or neighbouring. This allows speeding up the memory access and reducing the power at the same time by accessing only the required bits. The programmable circuitry is configured to receive instructions such as manifest loop instructions and even manifest loop nest instructions from an instruction set processor which are used to program the programmable circuitry. Once the programmable circuitry is programmed, the programmable circuitry autonomously accesses and optionally processes the stored data by controlling the reads or writes of bits in accordance with the received instructions. This eliminates the need for the instruction set processor to generate and send each memory address over the memory bus.

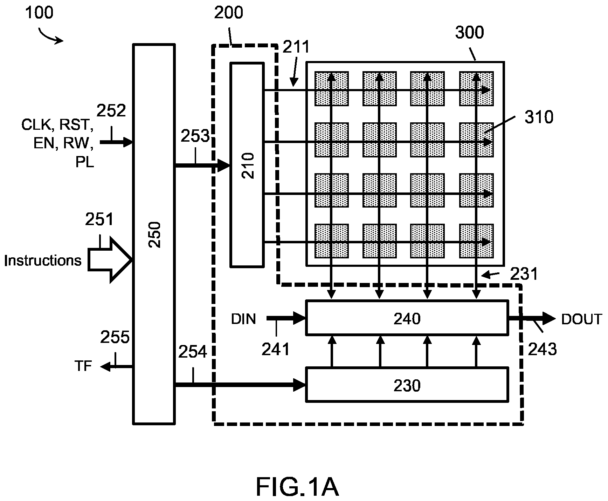

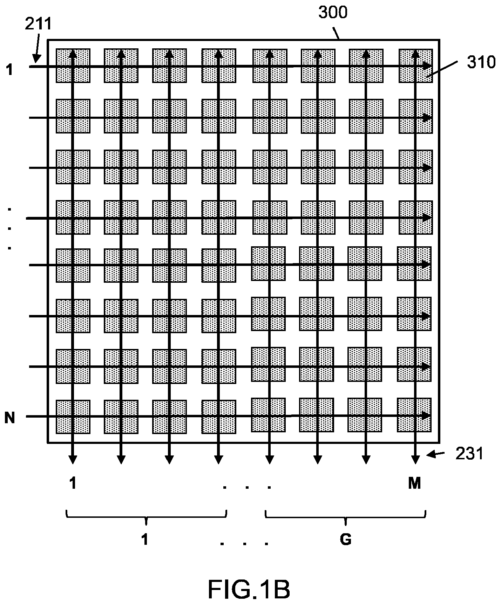

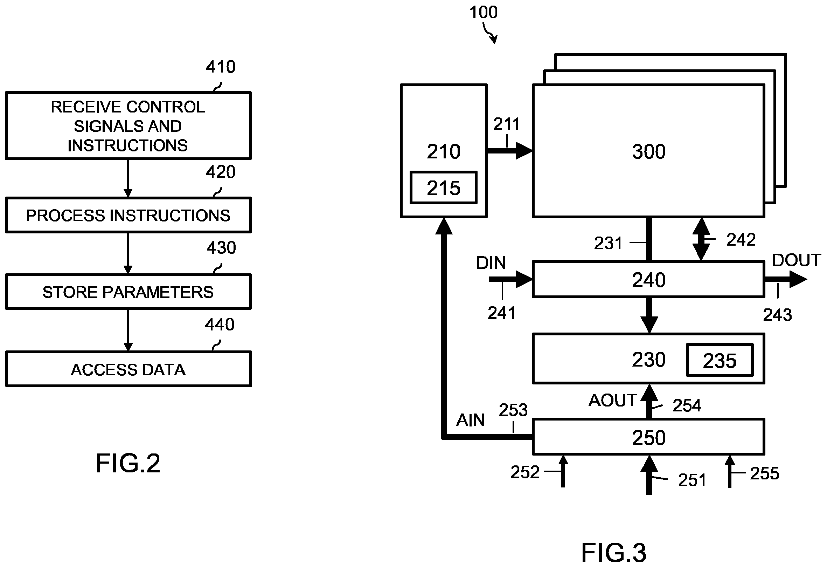

The memory macro and the implementation of the programmable circuitry according to the present disclosure will be explained in more detail below with reference to FIG.1A showing an example block scheme illustrating relevant components of the proposed memory macro and FIG.1B showing the memory array and FIG.2 showing the various steps performed by the programmable circuitry, in more detail.

FIG.1A shows an example block scheme of a memory macro 100 according to an embodiment of the present disclosure comprising a two-dimensional memory array 300, a periphery circuitry 200, and a programmable circuitry 250. The memory macro may be volatile such as Flash, Resistive RAM, e.g. OxRAM, and Magnetic RAM, e.g. STT-RAM, or a non-volatile such as Dynamic RAM, DRAM, and Static RAM, SRAM. The memory array 300 comprises a matrix of NxM bit cells 310 arranged in N rows, R, and M columns, C, each of bit cells storing one bit of data. The columns are bundled in G segments of data words, each consisting of D bits. Each row of bit cells is connected to a word-line 211 and each column of bit cells to a bit-line 231, shown in more detail in FIG.1B. The number of address bits is A which defines the word addresses X as X=2^{A}. There are W=R^{∗}G memory words in total, or B=R^{∗}C bits in total.

The parameters characterizing the memory array may thus be summarized as follows:
- number of address bits, A
- number of data bits, D
- number of segments, G
- number of word addresses X, and X= 2^{A}
- number of rows, R, and R = int(X/G)
- number of columns, C, and C = D^{∗}G
- number of words W, and W = R^{∗}G (≤ X)
- number of bits, B, and B= R^{∗}C.

Typically, the parameters A, D, and G characterizing the memory array are derived based on the application requirements. To do so, the source code of the application may be profiled by a code profiler to derive these parameters. Once, the parameters A, D, and G are derived, the other parameters characterizing the memory array, i.e. the R, C, B, W and X, are derived therefrom as detailed above.

The periphery circuitry 200 comprises a row and a column logic, also commonly referred to as an input logic 210 and an output logic 240, which respectively drive the word-lines 211 and bit-lines 231 of the memory array to control how data is written into or read from the memory array.

The programmable circuitry 250 comprises a set of programmable registers and a control logic (not shown in the figure). The programmable circuitry 250 is configured to receive 410, via the control interface 252, control signals such as enable, EN, clock, CLK, reset, RST, read-write, RW, signals and end of cycle, TF, signal. These signals EN, CLK, RST, RW and TF correspond to the control signals of conventional memory macros. In addition to those, the proposed memory macro receives a parallel load, PL, signal that enables the read or write of words located at a set of at least one non-neighbouring columns and at a set of rows. The set of rows comprises one or more sequential or nonsequential rows. The programmable circuitry 200 is further configured to receive 410, via a program interface 251, manifest loop instructions from an instruction set processor.

The manifest loop instructions comprise instructions implementing a loop structure indicating how and in what order data should be processed and the loop iterator based conditions to be satisfied. For instance:

```
      FOR n=l TO N
           FOR m=l TO M
           A[n,m]= A[n,m-1] + B[n-1,m];
                IF (n>m)
                  C[n,m]= A[n,m] ∗ B[n-l,m];
```

In this example, the loop structure comprises instructions of two "for" loops nested in one another. Such a loop structure may be represented by a set of manifest loop instructions as the loop conditions are data-independent, i.e. the loop structure only contains the loop iterators n and m. The strides in this case are increment by 1 for both n and m. Other integer numbers higher than 1 are also possible. For example, that increment may be 2 which means the stride is doubled. For a loop structure to be represented by manifest loop instructions, the increment value of the loop iterators should be a constant and that the loop conditions may not contain data-dependent condition such as if (A[n,m] >0).

The instructions may include one or more logic operations, such as logical "AND" and "OR" operations, or one or more arithmetic operations, such as addition, subtraction, multiplication, division. Further, the manifest loop instructions may comprise a stride operation that defines how the data is indexed within the loop structure.

The memory array is loaded with input data, DIN, via the input data terminal 241. The data may then be processed according to the manifest loop instructions as follows.

At a first step 410, the programmable circuitry 250 receives the manifest loop instructions via a program interface 251 as well as the control signals EN, CLK, RST, RW, PL and TF. The manifest instructions are in the form of lower-level instructions understandable by the control logic, such as assign, select, shift operations. These instructions may be provided by an instruction set processor or similar, for example. In a following step 420, the programmable circuitry 250 processes the instructions, i.e. the programmable circuitry 250 translates the manifest loop instructions to derive a set of parameters characterizing the loop structure. The parameters include:
- a memory address pattern, U;
- a start memory address, P;
- a stride, S; and
- a number of loop iterations, L.

The loop iteration parameter L indicates the number of times the manifest loop instructions are to be executed for the corresponding loop iterator, while the other parameters indicate which data is to be processed. The memory address pattern, U, indicates the bit cells to be selected or addressed. In other words, the memory address pattern indicates the sequence of bit cells to which data is written into or read from. The start memory address, P, indicates the start location in the memory from which the bit cells are to be selected, i.e. from which row and column of the memory array the bit cells indicated by the memory address pattern, U, are to be selected. The memory address pattern, U, and the start memory address, P, together form the start memory address. The stride, S, parameter indicates how to derive the next memory address for a subsequent value of the loop iterator.

Typically, the first index in the memory address pattern U indicates the start memory address, P, however in cases where the rows and columns of the memory array are very long it may be useful to provide the start memory address as a separate parameter, P, to maintain the memory address pattern relatively short. Optionally, the resulting start memory address may be masked using a mask pattern, M.

However, in case the number of bits of the start memory address, P, is very large (e.g. 2048 bits) and the width of the program interface 251 is relatively small (e.g. 32 bits), then 64 cycles will be required for the instruction set processor to program the starting pattern and another 64 for the mask pattern. This is a large programming overhead if only a small section of the memory array is to be addressed. In such cases, the instruction set processor may issue a reset command, RST, 252 to instruct the programmable circuitry 250 to the reset the pattern parameters with a single command. The instruction set processor may then program the relevant pattern sections in only a few additional commands. Alternatively, this programming functionality may be performed directly with the reset command, RST, itself, however, at the cost of more hardware.

Depending on the manifest loop instructions, the programmable circuitry may need to control the operation of either of or both the input and output logic independently. In the latter case, the memory address pattern U will comprise a row selection pattern, Ur, indicating the pattern of word-lines to be addressed and a column selection pattern, Uc, indicating the pattern of bit-lines to be addressed, and, the parameter P will comprise an initial column, Pc, and an initial row, Pr. Similarly, the parameters L and S may respectively comprise different values for the row and columns. Similarly, the mask pattern M may be different for the row and columns.

The memory address is thus decoded into a row pointer and a column pointer, which effectively selects one or more groups of consecutive bits from the memory array 200 in accordance with the values of the derived parameters, for example:

```
      L = 10
      Uc = 10100011 // column address pattern
      Pc = start_col // start column location
      Sc = 2 //address every second column
      Ur = 00000010 // memory address pattern
      Pr = start_row // start row location
      Sr = 2 //address every second row
```

In other words, the memory bits are accessed by a respective unique combination of a row and a column number in the case of a two-dimensional array or by a unique combination of a row, column and a page number in a three-dimensional array, just as two or three orthogonal planes define a point in two- or three-dimensional space.

In a next step 430, the derived parameters are stored in the programmable registers and the lower-level instructions are loaded in the control logic which effectively programs the programmable circuitry to process the data stored in the memory array in accordance with the manifest loop instructions.

The size of the registers U, P, S, and L may be determined based on the size of the register storing the G parameter. In practice, their size in bits may be chosen to be at least equal to log2(G). For example, if the number of segments G in the memory array is 256, i.e. G=256, the size of registers U, P, S, and L may be 8 bits.

In a final step 440, the control logic of the programmable circuitry controls the operation of input and output logic, i.e. its input and output drivers, of the memory macro in accordance with the lower-level instructions and the derived parameters.

For the example illustrated above , in the first loop iteration, the column pointers will select columns 1, 3, 7 and 8 starting from Pc=start_col which value is derived from the manifest loop instructions and the physical memory locations that have been decided by the linker. The column pointer will thus select columns start_col+1, start_col+3, start_col+7 and start_col+8 , i.e. for the positions in Uc where "1" is present. In the next iteration, because the stride parameters Sc is set to 2, the column pointers will again select columns 1, 3, 7 and 8 but this time starting from start_col+3, i.e. it will access columns start_col+3, start_col+5, start_col+9 and start_col+10. Because a parallel access is enabled, i.e. PL=1, at each iteration four columns are read or written concurrently until the loop condition is satisfied. In this example, the loop condition is satisfied when 10 iterations are completed, i.e. L=10. Similarly, in the first loop iteration, the row pointers will select row 7 starting from Pr=start_row. In the next iteration the row pointers will select row 9 and so on. By doing so, the data stored in the memory is accessed in accordance with the manifest loop instructions. Once the manifest instructions have been executed, i.e., the memory array addressing is completed, the programmable circuitry 250 issues an end of cycle notification, TF, 255 to notify the instruction set processor of the completion of the data processing and outputs the process data, DOUT, at the data output 243 of the memory macro.

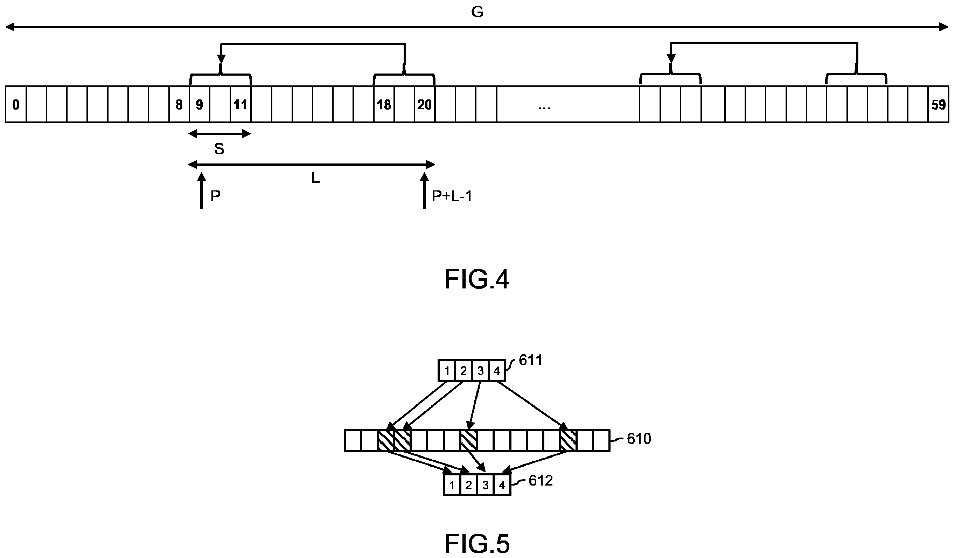

FIG.4 shows how data is accessed according to the values stored in the programmable registers. In this example, the number of word segments G, which is determined at design time, is 60. The registers holding the values of U, P, S, and L parameters are set to have a size of 8 bits. In this example, it is assumed these parameters refer to the columns only. The value of U = "10100000" P = "start_col", S = 3; L = 4, indicate that the first and the third column starting from start_col+1 will be accessed in parallel and then this will continue with other column pairs in subsequent iterations, with a stride of 3 and until the number of iterations L is reached. In other words, at each loop iteration, the values of U and P parameters stored in the respective registers will be shifted in accordance with the stride value S. If we assume that the start_col is initialized as 8, then in the first loop iteration, columns 9 and 11 will be selected, in the second iteration columns 12 and 14, and in the last iteration, i.e. the fourth iteration, the columns 18 and 20 will be selected. In other words, at every iteration, the data stored at the selected bits will be processed.

FIG.5 shows an example of simultaneously accessing memory words in a specific segment, for example in the first segment, of a row in the memory array. In this example, the row pointer is set to Ur = "0010000000000000" and the column pointer is set to Uc = "0011000100000100" to write the words 611 in the memory address selected in according to the values of the Ur and Uc. Assuming that Pc and Pr are set to 0. Then, the words 611 will be written at the bit cells at the intersection of row 3 and columns 3, 4, 8, and 14. Similarly, the same values of the parameters may be used to simultaneously read the stored data from these bit cells. By modifying the value of Ur and Uc different words may be written or read from the memory array. For example, by setting the row pointer address to Ur = "0000001100011000", and with Pr set to 0 again, the words from rows 7, 8, 12 and 13are simultaneously fetched. Further, the data read may be performed in a sequential manner rather than in parallel as shown in the figure. This may also be done by selected the required bit cells in series.

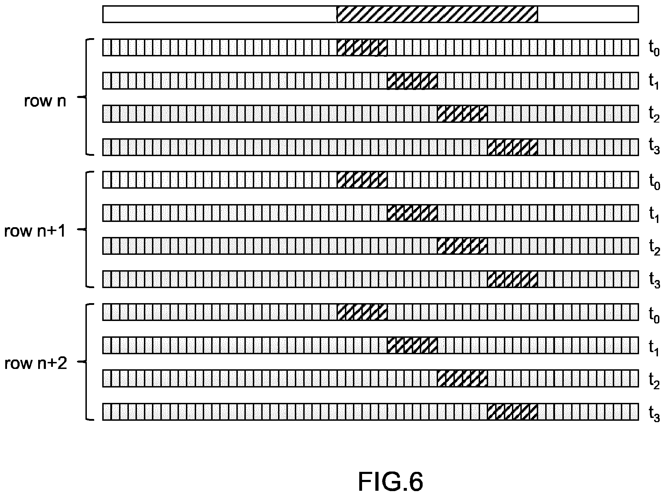

FIG.6 shows a further example of how a rectangular pattern in a two-dimensional memory array may be fetched by employing the proposed memory macro. Herein, instead of accessing a single row at a time as in conventional memory solution, words from N number of rows may be fetched simultaneously. In this example, six subsequent data words are accessed in rows n, n+1, and n+2, simultaneously with a single fetching operation. The fetching operation is repeated four times. Thus, in total 24 words are accessed in a respective row which are read in groups of 6 over four clock cycles. The values of the parameters U, P, S, and L are derived according to similar rules as described above.

In case the manifest instructions comprise instructions of nested loops, the programmable circuitry may be configured to support several hierarchically stacked row and column pointers or hierarchically stacked shift registers. In this case, the lower layer pointers, i.e. the row and column pointers of the innermost loop structure, are controlling how the row and column pointers of the outermost loop structure shift at every loop iteration. For example, in case of two or more nested "for" loops, the rotating shift register corresponding to the inner loop starts again at the initial position, i.e. the start memory address, when the end of the loop, indicated by L, is reached. At that time also the outer loop iterator is shifted by the value of the stride parameter of that outer loop.

FIG.3 shows another example block scheme of a memory macro 100 according to an embodiment of the present disclosure comprising a two-dimensional memory array 300, a periphery circuitry 200 and a programmable circuitry 250 where a part of the programmable circuitry, namely the programmable registers 255 are forming part of the periphery circuitry 200. In this example, the programmable registers 215 for controlling the operation of the input logic are included in the input logic 210 and the programmable registers 235 for controlling the operation of the output logic are included in the output logic 230. The operation of the memory macro 100 remains the same as described with reference to FIG.1 and FIG.2.

The memory array may be two or three dimensional. A three-dimensional array may be formed by stacking several two-dimensional arrays on top of each other. A single data word may then be accessed by a unique combination of a row, column, and a page number, just as three orthogonal planes define a point in three-dimensional space. Further, the memory array may be extended to have an even higher dimensional memory organization. Mathematically, a memory array may be compared to a K-dimensional space, in which a point, i.e. a memory address, is defined by K crossing orthogonal hyperplanes with each hyperplane having a dimension of K-1. The point coordinates are therefore a vector in K-dimensional space.

For simultaneously accessing multiple rows, columns or pages, the concept of address pattern is employed as detailed above. Instead of a single coordinate that defines the position of one hyperplane, address patterns of 0's and 1's for each respective dimension of the memory array are defined. The position of a 1 determines that the corresponding memory hyperplane is selected. Note that in a conventional memory, each pattern would contain a single 1, while all other entries are 0. This is commonly referred as "one-hot". As described above, the pattern length for a respective dimension of the memory array may correspond with the number of available hyperplanes in that dimension. Thus, the address patterns may also be referred to as hyperplane patterns.

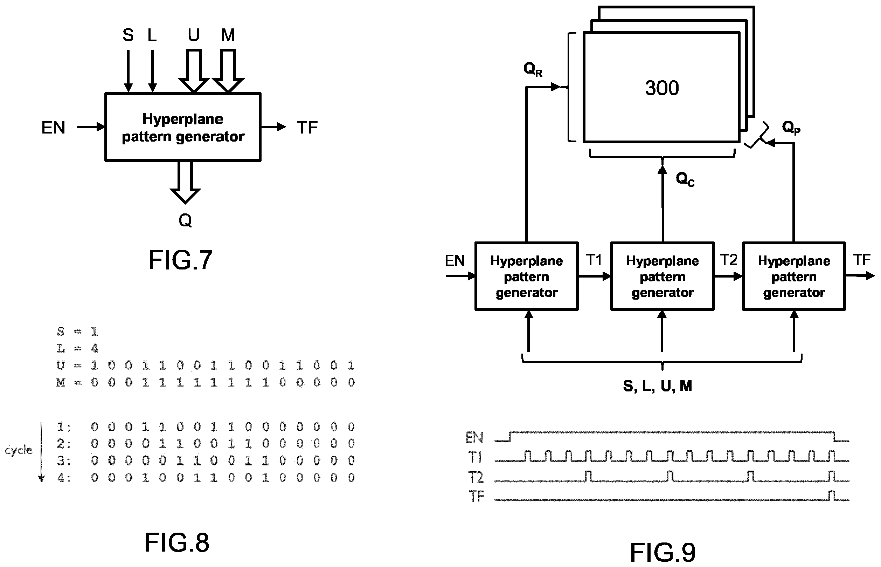

FIG.7 shows an example of a hyperplane pattern generator. The pattern generator may be used for generating the hyperplane patterns for the row, column, or page of the memory array. The set of parameters derived from the manifest loop instruction included the stride value S, the loop iteration count, L, the starting memory address pattern, U, and, the optional mask pattern, M, are provided to the hyperplane pattern generator. FIG.8 shows their respective values. The hyperplane generator comprises a set of programmable registers for storing the respective parameters and a control logic controlling their operation.

Herein, the starting memory address pattern U defines the initial string of 1's and 0's in the first memory cycle. For the next iteration or cycle, the U pattern will be shifted by the stride value S. The stride value may be positive or negative, or even zero. This shifting process is repeated by the number given in the iteration count L. The resulting pattern is masked with the optional mask pattern M to finally form the output pattern, Q, as shown in FIG.8. Once, the set of parameters are loaded in the hyperplane pattern generator, the pattern generation will start generating the output pattern Q when the enable signal EN is activated. After the last iteration, i.e. once the shifting process is repeated the required number of iterations as specified by the iteration count L, a termination flag, TF, is raised, which can be used to enable a next pattern generator, or to flag the host that the whole process has finished.

When the stride value would cause a shift outside the available pattern range, the actual shift distance should be taken modulo-N, where N is the number of pattern bits. Bits that are shifted out at one side will be shifted in at the other side (i.e. "rotation"). The mask pattern can be used to confine the dynamic hyperplane activations to a static selection.

Because the stride value S can have any value, the hardware implementation of a pattern shifting register can become quite complex, i.e. every register bit needs a very large input multiplexer. In the case of a 32-bit register, the range of the stride value may be [-31:+31]. The stride value can select any register bit as the next value. In this case, 32 multiplexers are needed for selecting any one of the register bits forming a 32-bit left/right shift register multiplexer. The hardware complexity may be reduced by limiting the range of the stride value, S. For example, if the stride value is limited to the range [-3:+3], the number of the required multiplexer inputs will be limited to only 7, which drastically reduces the hardware complexity. This clearly shows there is a trade-off between shifting flexibility and hardware implementation complexity, which must be determined at design time.

FIG.9 shows an exemplary embodiment of a programmable circuitry implementation for a three-dimensional memory array. The programmable circuitry will thus comprise three such hyperplane patterns generators, one for each dimension of the memory array, i.e. rows, columns, and pages, each accompanied with an individual stride and iteration count parameters. The waveforms show how the three pattern generators are concatenated to hierarchically form the final memory hyperplanes (for example, row first, then column, and page last).

In practice, the number of hyperplane pattern bits may be larger than the number of data words that are supported by the memory data port (i.e. I/O). That sets a limit to the number of pattern bits that can be 1 simultaneously. For instance, if the memory word size is 32 bits and the memory data port is 128 bits, then maximum 128/32 = 4 words can be accessed at the same time. This means, that the number of pattern bits that can be simultaneously 1 should be 4 as there is simply no physical bandwidth to push more than 4 data words in and out. FIG.5 illustrates an example of how to read and write memory words in such a case.

The assignment of write data and selection of read data to/from the enabled hyperplanes (i.e. columns in a two-dimensional memory) is done by special assign and select units. In conventional memories with the single-bit patterns, data assignment is simply done by enabling the bit line driver of the selected column, whereas data post-selection is implemented with a (large) multiplexer. Herein, however, the assign and select is more complicated, as multiple hyperplanes selection is enabled. More particularly, the input data words are now assigned one by one to the currently enabled memory hyperplanes, whereas the output data are multiplexed into the output data word in the order as they appear in the hyperplane pattern. Note, that excess words will be rejected, and absent words will be filled with zeros. The complexity of this multiplexer is comparable to that of the left/right shift register multiplexer with a limited number of inputs as described above.

Further, to enable an arbitrary selection of the memory columns to be accessed simultaneously, each column of the memory array must have its own write driver and read sense amplifier. In current memory technologies, however, only a single row can be enabled at any time, but it is envisaged that future memory technologies may enable writing and/or reading multiple memory cells on the same column. Enabling arbitrary selection of the memory rows as well will of course considerably complicate the design of memory cell, bit line drivers and sense amplifiers. In such case, a multi-valued logic may be used.

To assess the effect of the proposed memory macro, a test case on a conventional memory macro *stt_memory* with a single row, single segment access, and the proposed memory macro *stt_acamem* with a single row, multiple segments access is shown below.

Test benches have been used to generate random input data to write to the specified words in memory. Then the same memory locations are read out again and compared with the expected data. Both for writing and reading the dissipated energy is monitored and the integrated numbers are reported when simulation finishes.

The energy and power parameters are read from an input file. Also, the array word locations are read from a file.

For the test, a rectangle [(x1,y1)...(x2,y2)] with (x1,y1) = (21,19), (x2,y2) = (31,23) in a memory array of size [G,R] is accessed. The parameters defining the memory array are set as follows: D=8, G=64, R=64.

The code block *stt_memory* implements a conventional memory macro and includes the code blocks for the memory array model and the conventional row and col decoders, respectively. The design hierarchy for such a conventional memory is as follows:

```
      stt_memory -- classical memory interface
            stt_rowdec -- row decoder
            stt_coldec -- column decoder
```

The code block *stt_acamem* implements the proposed memory macro and includes the code blocks for the memory array model and the programmable circuitry, respectively. The design hierarchy is as follows:

```
      stt_acamem --(MRAM memory with ACA wrapper)
            aca_assign - implements a data write into relevant segments
            in memory array
            aca_select - implements data read from relevant segments in
            the memory array
            aca_rowcol -- implements row and columns decoders -> WL, DL
            aca_shireg - implements programmable shift or rotation
            registers
      stt_analog - implements the memory array and the analog
      driver/sense amplifier periphery
```

The memory matrix contains R rows and G word column groups. One column group, i.e. a segment, accesses a word of D bits simultaneously. Multiple word columns may be accessed at the same time. The number of input and output words that can be supplied or retrieved in one clock cycle is defined by the parameter N. The parameters SR and SC represent the strides for the rows and columns, respectively.

The memory interface of the proposed memory macro is as follows:

```
      entity stt_acamem is
      generic (R, G, SR, SC, N, D: natural);
      port (
      RST: in std_logic; -- asynchronous reset
      CK: in std_logic; -- clock
      EN: in std_logic; -- enable
      RW: in std_logic; -- read (0) / write (1)
      Ur: in std_logic_vector(R-1 downto 0); -- row init register
      Pr: in std_logic_vector(SR-1 downto 0); -- row starting point
      Sr: in std_logic_vector(SR-1 downto 0); -- row stride
      Lr: in std_logic_vector(SR-1 downto 0); -- row loop size
      Uc: in std_logic_vector(C-1 downto 0); -- column init register
      Pc: in std_logic_vector(SC-1 downto 0); -- column starting point
      Sc: in std_logic_vector(SC-1 downto 0); -- column stride
      Lc: in std_logic_vector(SC-1 downto 0); -- column loop size
      PL: in std_logic; -- parallel load
      TF: out std_logic; -- end cycle flag
      DIN: in std_logic_vector(N∗D-1 downto 0); -- input data
      DOUT: out std_logic_vector(N∗D-1 downto 0) -- output data
      );
      end;
```

Compared to the classical memory interface *stt_memory* instead of having one address port, herein there are 11 new ports. The *aca_assign* instruction assigns a number of words from an input word array and assigns them to the output word array according to the bit values in a pointer array. The output array can be longer than the input array.

The input words DIN may be right-aligned. Other alignments are also possible. The number of assigned output words DOUT can be less than, equal to, or larger than the available number of input words. In the latter case, the associated output words are filled with zeros.

The interface of the *aca_assign* code block is as follows:

```
      entity aca_assign is
      generic (D, G, N: natural);
      port (
      EN: in std_logic; -- enable
      PT: in std_logic_vector(G-1 downto 0); -- assignment pointer bits
      DIN: in std_logic_vector(N∗D-1 downto 0); -- input data array
      DOUT: out std_logic_vector(G∗D-1 downto 0) -- output data array
      );
      end;
```

The enabling signal EN which enables the memory array for reading or writing and the memory address pattern PT defines which rows or columns of the memory array are to be selected. The interface is organized to implement either read or write that is defined by the value of the parameter RW.

The *aca_select* instruction selects a number of words from an input word array according to the bit values in a pointer array and concatenates them in the output word array. The output words DOUT are, for instance, right-aligned into the output array. The number of selected input words DIN can be less than, equal to, or larger than the available number of output words. In the first case, empty output words are filled with zeros; in the latter case, the surplus input words are rejected. The interface of the *aca_select* instruction is as follows:

```
      entity aca_select is
      generic (D, G, N: natural);
      port (
      EN: in std_logic; -- enable
      PT: in std_logic_vector(G-1 downto 0); -- selection pointer bits
      DIN: in std_logic_vector(G∗D-1 downto 0); -- input data array
      DOUT: out std_logic_vector(N∗D-1 downto 0) -- output data array
      );
      end;
```

, wherein N indicates the number of words to be written, G indicates the number of word column groups and D the number of bits in a word. Similarly to above, the interface is organized to implement either read and write that is defined by the value of the parameter RW.

The code block *aca_shireg* implements the **shift and rotation logic** of the programmable circuitry 250 capable of reading multiple groups of consecutive bit cells simultaneously.

The interface of the *aca_shireg* block is as follows:

```
      entity aca shireg is
      generic (P, S: natural);
      port (
      RST: in std_logic; -- asynchronous reset
      CLK: in std_logic; -- shift clock
      EN: in std_logic; -- enable clock
      EC: in std_logic; -- enable counting
      PL: in std_logic; -- parallel load (init)
      PD: in std_logic_vector(S-1 downto 0); -- starting point
      SD: in std_logic_vector(S-1 downto 0); -- shift distance
      LD: in std_logic_vector(S-1 downto 0); -- repetition count
      DI: in std_logic_vector(P-1 downto 0); -- parallel load data
      QO: out std_logic_vector(P-1 downto 0); -- output data
      TC: out std_logic -- terminal count
      );
      end;
```

The code block *aca_rowcol* implements the row and column programmable logic of the programmable circuitry 250. It contains two *aca_shireg* blocks, one for each row and column pointer generation. The interface of the *aca_rowcol* code block is as follows:

```
      entity aca_rowcol is
      generic (R, G, SR, SC: natural);
      port (
      RST: in std_logic; -- asynchronous resetInterface:
      CLK: in std_logic; -- shift clock
      EN: in std_logic; -- enable
      PL: in std_logic; -- parallel load
      Pr: in std_logic_vector(SR-1 downto 0); -- row starting point
      Sr: in std_logic_vector(SR-1 downto 0); -- row stride
      Lr: in std_logic_vector(SR-1 downto 0); -- row loop size
      Pc: in std_logic_vector(SC-1 downto 0); -- column starting point
      Sc: in std_logic_vector(SC-1 downto 0); -- column stride
      Lc: in std logic_vector(SC-1 downto 0); -- column loop size
      RD: in std_logic_vector(R-1 downto 0); -- row parallel load data
      CD: in std_logic_vector(G-1 downto 0); -- column parallel load
      data
      RO: out std_logic_vector(R-1 downto 0); -- row output data
      CO: out std_logic_vector(G-1 downto 0); -- column output data
      TF: out std_logic -- end of cycle flag
      );
      end;
```

In this illustration, all ACA-related inputs are initialized to zero, except the parallel load signal PL, which is set to '1' to enable parallel load. In addition, the RST signal must now be taken into account.

For the conventional *stt_memory* the memory addresses are generated in the testbench as follows:

```
      for y in y1 to y2 loop
            for x in x1 to x2 loop
                  address := G∗y+x;
            end loop;
      end loop;
```

The memory addresses for the *stt_acamem* are derived from the values of the parameters stored in the registers.

The simulation results are as follows:

```
      run stt memory -a 12 -d 8 -g 64 -v ori
      # A=12, D=8, G=64: W=4096, B=32768, R=64, C=512
      # Simulation finished successfully at 2.99712 us
      # Rectangle coordinate values: 21 19 31 23
      # Primitive energy values [fJ]: 1.000 1.000 1.000 1.000 2.000
      3.000
      # Number of energy sinks: 1029
      # Write time: 1471.80 ns
      # Read time: 1525.32 ns
      # Total write energy: 354.622 pJ Total write power: 240.944 uW
      # Total read energy: 11.480 pJ Total read power: 7.526 uW
```

The same test was performed on the proposed memory *stt_acamem* which is defined to have the same size as the conventional memory array. The parameters for the row and column registers of the programmable circuitry have been pre-set as follows:

```
      Ur <= (others => '0');
      Ur(y1) <= '1';
      Pr <= y1;
      Sr <= 1;
      Lr <= y2-y1+1;
      Uc <= (others => '0');
      for i in x1 to x1+N-1 loop Uc(i) <= '1'; end loop;
      SC <= x1;
      Cs <= N;
      Lc <= x2-x1+1;
```

The programmable circuitry then generates the row and segment pointers in accordance with the parameters above. The simulation results are as follows:

```
      run stt_acamem -n 1 -d 8 -g 64 -r 64
      # N=1, D=8, G=64: W=4096, B=32768, R=64, C=512
      # Simulation finished successfully at 2.981064 us
      # Rectangle coordinate values: 21 19 31 23
      # Primitive energy values [fJ]: 1.000 1.000 1.000 1.000 2.000
      3.000
      # Number of energy sinks: 1029
      # Write time: 1447.716 ns
      # Read time: 1471.80 ns
      # Total write energy: 352.982 pJ Total write power: 243.820 uW
      # Total read energy: 7.925 pJ Total read power: 5.384 uW
```

As it can be seen, the write energy is about equal, because it is dominated by the MTJ write current. However, the read energy is down from 11.48 to 7.93 pJ, i.e. a reduction of 30% is achieved. This is due to the less address decoding.

In practice, most applications are read-dominated, due to the abundant "data reuse" present in the popular matrix, neural network, image, and video kernels. Thus, a gain in read energy is of high interest for the majority of the realistic applications.

In case a larger external word size (e.g. N=4) is used, then the following results are obtained:

```
      run_stt_acamem -n 4 -d 8 -g 64 -r 64
      # N=4, D=8, G=64: W=4096, B=32768, R=64, C=512
      # Simulation finished successfully at 0.840264 us
      # Rectangle coordinate values: 21 19 31 23
      # Primitive energy values [fJ]: 1.000 1.000 1.000 1.000 2.000
      3.000
      # Number of energy sinks: 1029
      # Write time: 377.32 ns
      # Read time: 401.40 ns
      # Total write energy: 387.745 pJ Total write power: 1027.639 uW
      # Total read energy: 4.821 pJ Total read power: 12.010 uW
```

As it can be seen, the energy needed to retrieve the same data from the proposed memory macro is only 4.82 pJ, i.e. a reduction of almost 60% is achieved. The read power increased, however, because the data are retrieved in a 4x shorter time. The above results indicate the energy savings inside the memory macro only. Thus, on top of these results, there are additional savings obtained in the conventional processor units or DMA engines generating the addresses, and in the buses transporting the address bits. That is due to the fact that many sequential accesses and their corresponding address instruction generation is now replaced by a large amount of concurrency with the parallel accesses/loads. Hence, the number of bus activations and address instruction generation cycles are significantly reduced.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A memory macro (100) comprising a memory array (300) and a periphery circuitry (200) configured to access the memory array, wherein the periphery circuitry comprises a programmable circuitry (250) causing the memory macro (100) to access data stored in the memory array in accordance with manifest loop instructions; the programmable circuitry comprising a control logic configured to control the operation of the periphery circuitry in accordance with a set of parameters derived from the manifest loop instructions.

2. The memory macro (100) according to claim 1, wherein the programmable circuitry (250) is configured, during operation, to receive the manifest loop instructions from an instruction set processor and to derive the set of parameters therefrom.

3. The memory macro (100) according to any one or the preceding claims, wherein the set of parameters comprises a memory address pattern, **U,** a stride, **S,** and a number of loop iterations, **L.**

4. The memory macro (100) according to claim 3, wherein the programmable circuitry (250) comprises a logic circuitry configured to perform a logical shift operation and to store the memory address pattern, **U,** and wherein the control logic is configured to shift the stored memory address pattern, **U,** in the logic circuitry in accordance with the stride parameter, **S.**

5. The memory macro (100) according to claim 4, wherein the logic circuitry comprises one or more rotating shift registers or one or more chains of shift registers.

6. The memory macro (100) according to claim 5, wherein the one or more rotating shift registers or the one or more chains of shift registers are hierarchically stacked and wherein the control logic is configured to control the shift registers such that the data stored in the memory array is processed in accordance with the manifest loop instructions.

7. The memory macro (100) according to any one of the preceding claims, wherein the periphery circuitry (200) is arranged to select one or more groups of consecutive rows of the memory array (300) in accordance with the set of parameters.

8. The memory macro (100) according any one of the preceding claims, wherein the periphery circuitry (200) is arranged to select one or more groups of consecutive columns of the memory array (300) in accordance with the set of parameters.

9. The memory macro (100) according to any one of the preceding claims, wherein the periphery circuitry (200) comprises an output logic (230) arranged to select columns (231) of the memory array (200), and wherein the programmable circuitry (250) is configured to control the operation of the output logic (230) in accordance with the manifest loop instructions.

10. The memory macro (100) according to any one of the preceding claims, wherein the periphery circuitry (200) further comprises an input logic (210) arranged to select rows (211) to the memory array (200), and wherein the programmable circuitry (250) is configured to control the operation of the input logic (210) in accordance with the manifest loop instructions.

11. The memory macro (100) according to any claims 9 or 10, wherein programmable circuitry (250) is configured, during operation, to derive a set of parameters for the input logic (210) and the output logic (230) respectively.

12. The memory macro (100) according to claim 11, wherein the memory address pattern, **U,** comprises a column selection pattern, **Uc,** and a row selection pattern, **Ur.**

13. The memory macro (100) according to any one of the preceding claims, wherein the memory array is a two- or a higher-dimensional array.

14. A method for controlling the operation of a memory macro according to any one of claims 1 to 13, the method comprising:
- obtaining (410) manifest loop instructions;
- deriving (420) a set of parameters based on the manifest loop instructions; and
- controlling (440) the operation of the memory macro in accordance with the set of parameters.

15. A processing system comprising a memory macro according to any one of claims 1 to 13.
